(19) Europäisches Patentamt / European Patent Office / Office européen des brevets

(11) **EP 2 413 149 A1**

(12) **EUROPEAN PATENT APPLICATION**

(43) Date of publication:
**01.02.2012 Bulletin 2012/05**

(51) Int Cl.:
*G01R 27/26* (2006.01)     *G01R 31/28* (2006.01)

(21) Application number: **11175637.5**

(22) Date of filing: **27.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.07.2010 US 368878 P**

(71) Applicant: **IMEC**
**3001 Leuven (BE)**

(72) Inventors:
• **Kim, Jaemin**
  **3001 Leuven (BE)**
• **Van der Plas, Geert**
  **3000 Leuven (BE)**
• **Marchal, Paul**
  **3052 Blanden (BE)**

(74) Representative: **Mackett, Margaret Dawn et al**
**Gevers Patents**
**Holidaystraat 5**
**1831 Diegem (BE)**

(54) **Capacitance measurement in microchips**

(57)     Described herein is a measurement system (300) for determining the capacitance of a device-under-test in an integrated circuit. The measurement system (300) comprises a reference circuit (310) and a test circuit (360). Each circuit (310, 360) comprises first and second diodes (320, 330, 370, 380) that are switched in accordance with a clock cycle to charge and discharge the as- sociated circuit (310, 360). A method is also disclosed that takes average current measurements for each circuit at one voltage level and processed them so that the ca- pacitance of a device-under-test connected to the test circuit (360) can accurately and reliably be determined. In a preferred embodiment, two voltage levels are used and adjustments are made for voltage threshold of the diodes and also their resistance.

*Fig. 3*

**Description**

Field of the Invention

The present invention relates to capacitance measurement in microchips, and is more particularly, although not exclusively, concerned with capacitance measurement of interconnects in such microchips.

Background to the Invention

In three-dimensional (3D) stacked integrated circuits (ICs) leading high density and high performance system integrations, vertical interconnection structures such as through-silicon-vias (TSVs) and microbumps have recently been added in comparison to conventional integrated circuit (IC) technologies. These structures contain electrically parasitic capacitances due to their physical dimensions. These parasitic capacitances tend to degrade system performance in high frequency bandwidths, so they can no longer be considered to be negligible in high speed operating systems even though the values of such parasitic capacitances are very small, typically, only tens of fF ($10^{-15}$F).

Conventional measurement techniques for parasitic capacitances use charge-based capacitance measurement (CBCM) techniques as described in articles entitled "Application of charge based capacitance measurement (CBCM) technique in interconnect process development" by Bothra, S.; Rezvani, G.A.; Sur, H.; Farr, M.; Shenoy, J.N., Interconnect Technology Conference, 1998. Proceedings of the IEEE 1998 International, Publication Year: 1998, Page(s): 181 to 183 (Bothra et al.) and "An on-chip, attofarad interconnect charge-based capacitance measurement (CBCM) technique" by Chen, J.C.; McGaughy, B.W.; Sylvester, D.; Chenming Hu; Electron Devices Meeting, 1996, IEDM '96., International, Publication Year: 1996 , Page(s): 69 to 72 (Chen et al.).

In the article by Bothra et al., a CBCM technique is described in which fF level inter-metal or interconnect capacitances between metal lines in different configurations are determined. Such parasitic capacitances are determined by a variety of interconnect structures with varying line width and spacing. The capacitance to be measured is connected in a circuit with n-channel metal oxide semiconductor field effect transistor (NMOS) and p-channel metal oxide semiconductor field effect transistor (PMOS) devices. Pulsing of gates in the NMOS and PMOS devices provides an average direct current which is proportional to the unknown capacitance. A reference structure is used to cancel parasitic capacitances due to the presence of junctions and metal lines, typically of the order of a few fF, by subtracting the capacitance from the result to provide the unknown capacitance value.

The article by Chen et al. describes on-chip or off-chip measurement techniques in which no reference capacitor is required and which can be used for the determination of interconnect geometry capacitances. A pseudo inverter configuration using NMOS and PMOS transistors, each having their own input gate, is connected to the interconnect whose capacitance is to be measured. One part of the pseudo inverter configuration is used as reference. The capacitance is determined from the slope of a graph of the network current and voltage applied to the pseudo inverter configuration.

In the capacitance measurement systems described above, the area of the test structure can be relatively large compared to the actual measurement device. In addition, a number of process steps are usually necessary for the construction of elements for the test structure.

Summary of the Invention

It is therefore an object of the present invention to provide a measurement circuit for ICs that has a smaller area than conventional test structures.

It is a further object of the present invention to provide a measurement circuit that can be implemented using fewer process steps compared to conventional capacitance measurement circuits.

In accordance with a first aspect of the present invention, there is provided a measurement system for measuring the capacitance of a device-under-test in an integrated circuit, the system comprising:

a first circuit forming a reference circuit; and
a second circuit forming a device-under-test circuit and into which the device-under-test is connected, the second circuit being substantially identical to the first circuit;
characterised in that the first and second circuits each comprise a first diode and a second diode, the device-under-test being connected between the first and second diodes of the second circuit.

By using diodes instead of n-channel and p-channel metal oxide semiconductor field effect transistors (NMOS and PMOS respectively) as in a conventional pseudo inverter configuration, it is possible to reduce the area of the measurement circuit as less probing pads are required. It is also possible to reduce the number of process steps needed for the construction of the measurement circuit when compared to the number of process steps required in the conventional pseudo inverter configuration. As a result, measurements can be performed at earlier stages of wafer fabrication thereby enabling an early assessment of yield.

Advantageously, the measurement system and the method of the present invention provides the ability to measure the capacitance of an interconnection by making use of structures which can be manufactured without gate process steps. In the past techniques, many patents and papers have been presented which rely on standard CMOS technology. The CMOS device should involve all of N-well, gate, N+, and P+ process steps, whereas the present invention only relies on structures which can be manufactured using only N+ and P+ process steps.

The first and second diodes each has a cathode and an anode, the cathode of the first diode being connected to the anode of the second diode in respective ones of the first and second circuits.

Each diode is switched on and off by applying a forward and a reverse bias respectively thereto.

In accordance with another aspect of the present invention, there is provided a method of measuring a capacitance value for a device-under-test using the measurement system described above, the method comprising the steps of:

a) connecting the device-under-test to the second circuit;
b) charging the first circuit by applying a first voltage level thereto;
c) measuring a first average current value of current flowing through the first circuit as it is charged;
d) charging the second circuit by applying the first voltage level thereto;
e) measuring a second average current value of current flowing through the second circuit as it is charged; and
f) determining the capacitance value for the device-under-test from at least the measured first and second average current values and the first voltage level.

In one aspect of the present invention, the method can estimate the capacitance of a device-under-test only with the PN diode manufacturing process such as typical MEMS manufacturing processes.

Step c) may further comprise applying a forward bias to the first diode and a reverse bias to the second diode so that the first circuit is charged, and discharging the first circuit by applying a reverse bias to the first diode and a forward bias to the second diode.

In addition, step e) may further comprise applying a forward bias to the first diode and a reverse bias to the second diode so that the second circuit is charged, and discharging the second circuit by applying a reverse bias to the first diode and a forward bias to the second diode.

The method of the present invention preferably further comprises the steps of:

g) charging the first circuit by applying a second voltage level thereto;
h) measuring a third average current value of current flowing through the first circuit as it is charged;
i) charging the second circuit by applying the second voltage level thereto;
j) measuring a fourth average current value of current flowing through the second circuit as it is charged;

and wherein step f) comprises determining the capacitance of the device-under-test from at least the measured first, second, third and average current values and the first and second voltage levels.

Step f) may further comprise adjusting the capacitance value for the device-under-test in accordance with a threshold voltage level of the first and second diodes of the first and second circuits.

In addition, step f) may further comprise adjusting the capacitance value for the device-under-test in accordance with a voltage difference due to turn-off resistance of the first and second diodes.

A clock cycle may be used to time the charging and discharging of the first and second circuits.

Brief Description of the Drawings

For a better understanding of the present invention, reference will now be made, by way of example only, to the accompanying drawings in which:-

Figure 1 illustrates a conventional CBCM method using a pseudo inverter structure;
Figure 2 illustrates a comparison between test structures and their respective areas for measurements where (a) shows the test area for a CMOS device based method and (b) shows the test area for a diode based device in accordance with the present invention;
Figure 3 illustrates a schematic representation of one embodiment of the present invention;
Figure 4 illustrates a schematic representation of one embodiment of the present invention that can be used to measure the capacitance of a through-silicon-via (TSV);
Figure 5 illustrates time domain waveforms of applied clock signals at charging and discharging nodes, the charging and discharging diodes turning on and off at the charging and discharging periods respectively;

Figure 6 illustrates time domain waveforms of applied clock signals and floating node voltages with a diode threshold voltage effect;

Figure 7 illustrates time domain waveforms of applied clock signals and floating node voltages with a diode turn-off resistance effect;

Figure 8 illustrates time domain waveforms of two kinds of applied clock signals for the method of the present invention;

Figure 9 illustrates a flow chart showing the steps for the calculation of device-under-test (DUT) capacitance in accordance with the method of the present invention; and

Figure 10 illustrates comparisons between error values obtained in capacitance values between a conventional measurement method and the method in accordance with the present invention for (a) width and length variations of a diode, (b) clock period variation, (c) first applied voltage variation, (d) DUT capacitance variation, (e) reference capacitance variation, and (f) diode voltage threshold variation.

Description of the Invention

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.

It will be understood that the terms "vertical" and "horizontal" are used herein refer to particular orientations of the Figures and these terms are not limitations to the specific embodiments described herein.

The move towards newer and smaller technologies is linked to scaling induced problems such as process variations. A method for measuring the capacitance of an interconnection or other device-under-test (DUT) is described below which can used in such technologies. The method enables the measurement of the capacitance of the interconnection or DUT, independently of any possible process variations.

The present invention will be described with reference to the measurement of the parasitic capacitance of vertical interconnections based on CBCM (charge based capacitance measurement) by using two diodes and controlling signals on diodes. In one embodiment, a method and system are disclosed to measure the parasitic capacitance of interconnections in a microchip. A diode-based capacitance measurement technique and a process variation de-embedding technique are also described.

In one particular embodiment of the present invention, the system and related method is applied to TSVs. However, it should be noted that system and method can also be used in traditional two-dimensional (2D) interconnection technologies and other 3D interconnection technologies. The system and method can be used to measure the capacitance of any interconnection in electronic circuits.

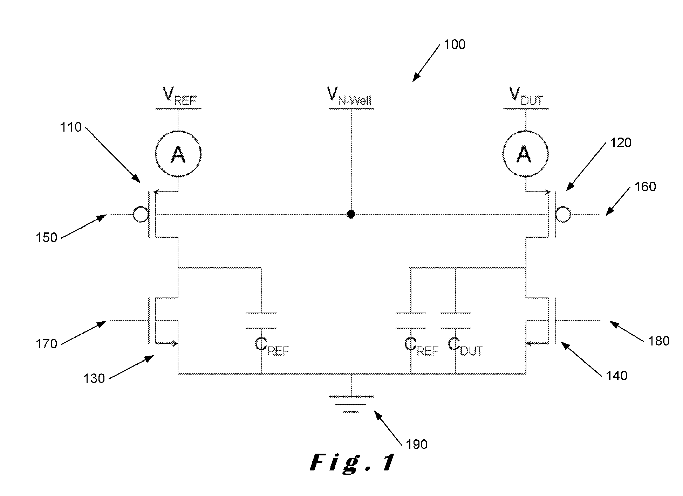

Referring initially to Figure 1, a conventional CBCM method is shown that uses a pseudo inverter configuration 100 requiring manufacturing processes for both NMOS and PMOS. The pseudo inverter configuration 100 comprises first and second PMOS devices 110, 120, and first and second NMOS devices 130, 140, each device having a signal input gate 150, 160, 170, 180 as shown. PMOS devices 110, 120 are connected to receive a reference voltage, $V_{REF}$, a voltage corresponding to an n-well, $V_{N-WELL}$, and a voltage for the DUT, $V_{DUT}$, as shown. The NMOS devices 130, 140 are connected to the ground 190 and reference capacitances, $C_{REF}$, are provided between each NMOS device and ground. In addition, a capacitance relating to the DUT, $C_{DUT}$, is also provided as shown.

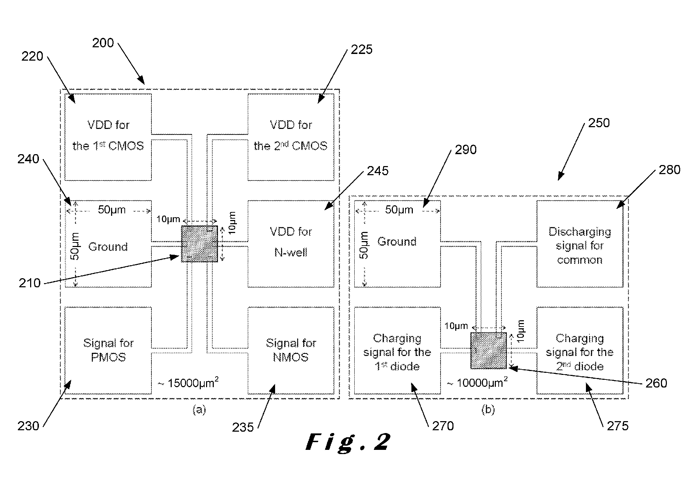

Figure 2 illustrates the required area to set test structures when CMOS devices, described above with reference to Figure 1, are used, as shown at (a). The test area for diode devices in accordance with the present invention are shown at (b).

A CMOS test structure 200 is shown at (a) that comprises a measuring device 210 connected to voltage pads 220, 225, signal pads 230, 235, a ground pad 240, and a voltage pad for N-well 245.

A diode test structure 250 in accordance with the present invention is shown at (b). A measuring device 260 is shown connected to charging signal pads 270, 275, a discharging signal pad 280 and to ground pad 290.

It is assumed that the measuring devices 210, 260, such as a CMOS device in (a) or a diode device in (b) have a size of 10$\mu$m-by-10$\mu$m and the probing pads each have a size of 50$\mu$m-by-50$\mu$m. As shown in (b), a single discharge pad is required and, therefore, the diode devices have a simpler configuration and a reduced test structure area of approximately, up to 33% (two less probing pads required) compared to the conventional CMOS-based test structure. As shown, a total area of approximately 150000$\mu$m$^2$ is required for the CMOS test structure compared to only approximately 100000$\mu$m$^2$ for the test structure of the present invention for the same measuring device size of approximately 100$\mu$m$^2$.

In particular, the prior art requires four process steps, namely, P+, N+, N-well, and gate. In contrast the present invention provides a measurement system without a gate process and there are only two process steps required, namely, P+ and N+.

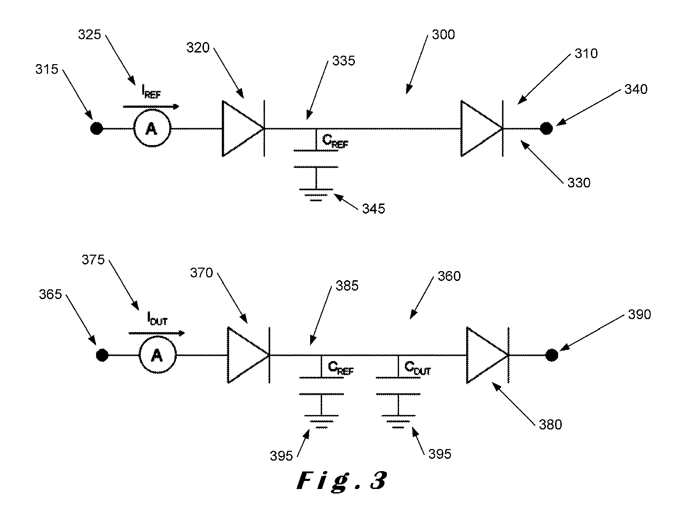

Figure 3 illustrates a schematic representation of a test system 300 in accordance with the present invention.

The system 300 comprises two circuits: a reference circuit 310, and a device-under-test (DUT) circuit 360 that includes the capacitance to be measured. Each circuit 310, 360 has a charging node 315, 365 connected to a charging diode 320, 370 via an ammeter 325, 375. The charging diode 320, 370 is connected to a discharging diode 330, 380 via a line 335, 385 and then to a discharging node 340, 390 as shown. Both circuits 310, 360 also contain a reference capacitance, $C_{REF}$, connected to the line 335, 385 and to ground 345, 395 as shown. In addition, the DUT circuit 360 includes a capacitance, $C_{DUT}$, which corresponds to the DUT being tested. $C_{DUT}$ is also connected to line 385 and to ground 395.

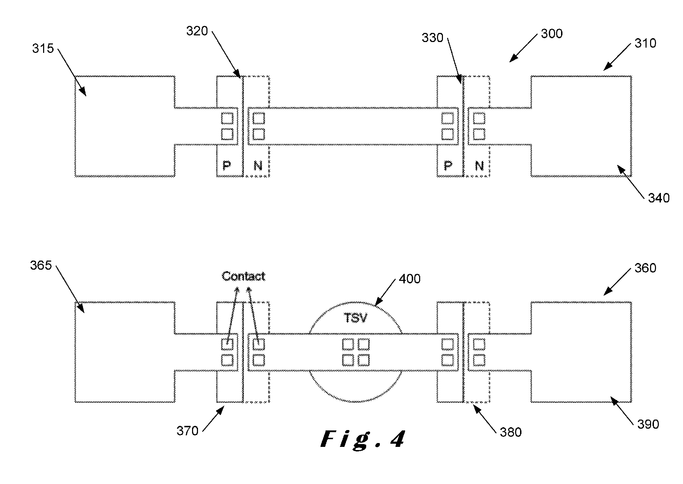

One use of the present invention is to measure the capacitance of a TSV 400 which is widely applied in 3D interconnection technology. Figure 4 illustrates a top view of the system 300 in accordance with the present invention. Components that have previously been described with reference to Figure 3 are numbered the same.

As before, the test structure 300 comprises a reference circuit 310 and a DUT circuit 360, each circuit having a charging node 315, 365 connected to a charging diode 320, 370, a discharging diode 330, 380, and a discharging node 340, 390 as shown. The TSV 400 is located in the DUT circuit 360 between the charging diode 370 and the discharging diode 380. As before, each circuit 310, 360 has the same configuration with the exception of the positioning of the TSV 400 in the DUT circuit 360.

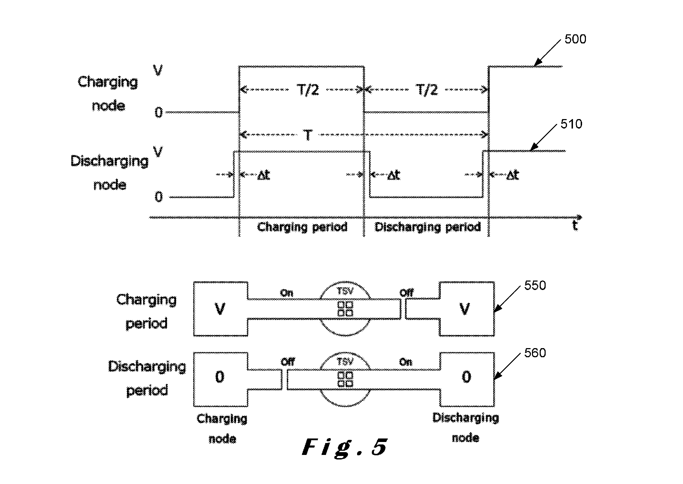

Operation of the test structure 300 in accordance with the present invention will now be described with reference to Figure 5. In Figure 5, two clock signals and switching on and off of the charging and discharging diodes are shown. Basically, a simple clock signal is used for the measurement. In order to control turning on and off of charging and discharging diodes independently, the two clock signals depicted in Figure 5 are applied on the charging and discharging nodes respectively as shown by clock signal 500 for the charging node and clock signal 510 for the discharging node. The DUT circuit of Figures 3 and 4 is also shown for the charging period and the discharging period where the charging diode is on and the discharging diode is off during charging and the charging diode is off and the discharging diode is on during discharging. This is shown by the circuits indicated as 550 and 560 respectively. Naturally, the reference circuit is also present but is not shown for ease of explanation. In addition, the reference circuit operates the same way as the DUT circuit.

The two clock signals have the same time period, T, but having slightly different duty cycles. As shown, the discharging node has a charging period of T/2 + 2∆t and a discharging period of T/2 - 2∆t. When charging, only the charging diode is turned on and the discharging diode is turned off. Therefore, the voltage applied at the charging node starts to charge the capacitance in the TSV located between two diodes and the current flows into the capacitance. In contrast, during discharging, only the discharging diode is turned on and the charging diode is turned off. The capacitance starts to drain charges from the capacitance to the discharging node. According to this switching mechanism, the turn-on and turn-off of two charging and discharging diodes are controlled in both the reference circuit (not shown) and the DUT circuit.

When the clock signal with the deterministic voltage is enforced to the capacitor and the average current value through the capacitor is measured, the capacitance can be calculated as follows:

$$C = \frac{T \times I_{AVG}}{V} \qquad\qquad (1)$$

where C is the capacitance of the target structure, the TSV in this case;

T is the time period of clock signal;
$I_{AVG}$ is the average value of measured current waveform through the DUT capacitance; and
V is the deterministic voltage level of clock signal applied to the capacitance.

In the simplest case, allowing for the capacitance of the rest of the circuit, the capacitance of the DUT, $C_{DUT}$, is determined as the difference between the equation (1) for the DUT circuit and equation (1) for the reference circuit. In particular, the capacitance of the DUT, $C_{DUT}$, can be determined as follows:

$$C_{DUT} = \frac{T(I_{AVG_{DUT}} - I_{AVG_{REF}})}{V}$$

where $I_{AVG\ DUT}$ and $I_{AVG\ REF}$ refer to the average current values in the DUT circuit and the reference circuit respectively.

It should be noted that the direct applied voltage to the capacitance is V in equation (1) for the calculation. However, the threshold voltage of diode distorts the value of V, so equation (1) is not necessarily valid for all measurements.

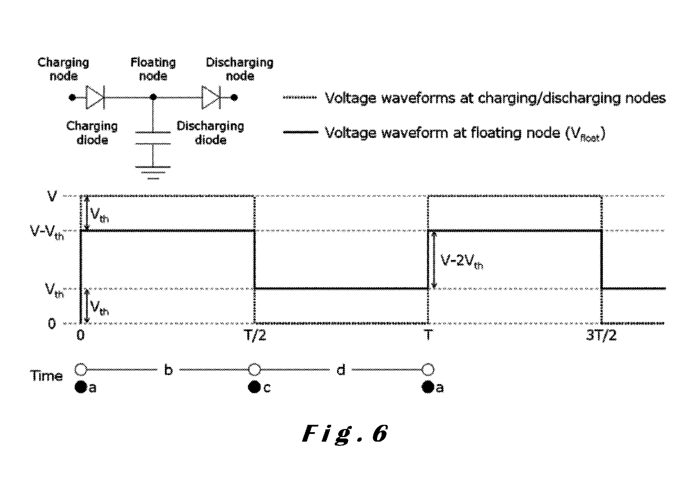

Figure 6 illustrates the principle of voltage distortion. It is assumed that $\Delta t$ in Figure 5 is small enough to be negligible compared to T in Figure 5, so clock signals at charging and discharging nodes have the same waveform as shown in Figure 6.

At the point 'a' in Figure 6, the charging diode is turned on and the current starts to flow into the DUT, as indicated by the capacitor attached to the floating node, in a very short time due to small resistance of the charging diode. When the voltage at the floating node, $V_{float}$, the node to which the DUT is connected, reaches to V - $V_{th}$, where $V_{th}$ is the threshold voltage of the diodes, the charging diode is turned off because the voltage between P and N nodes is lower than $V_{th}$. Therefore, $V_{float}$ keeps V - $V_{th}$ level during the period 'b'.

When the voltage on each of the charging and discharging nodes goes to zero at point 'c', the discharging diode is turned on and the charge retained within the DUT flows to the discharging node. $V_{float}$ rapidly decreases and stops at the $V_{th}$ level because the discharging diode is turned off due to lower voltage than the threshold voltage, $V_{th}$, and, the voltage at the floating node, $V_{float}$, holds the threshold voltage, $V_{th}$, during the period 'd'. The charging diode is turned on again, and the switching mechanism described above is repeated.

It will be appreciated that each diode has a cathode and an anode, the cathode of the first diode being connected to the anode of the second diode in the reference and DUT circuits, the DUT being placed between the cathode of the first diode and the anode of the second diode in the DUT circuit. It will also be appreciated that each diode is turned on by applying a forward bias thereto and a turned off by applying a reverse bias thereto. As a result, in the charging part of the clock cycle, the first diode is forward biased and the second diode is reverse biased and in the discharging part of the clock cycle, the first diode is reverse biased and the second diode is forward biased.

Accordingly, the applied voltage to the DUT swings from $V_{th}$ to V - $V_{th}$, not from 0 to V due to the threshold voltages of diodes. Therefore, the equation (1) for capacitance calculation can be revised as follows:

$$C = \frac{T \times I_{AVG}}{V - 2V_{th}} \qquad (2)$$

where $V_{th}$ is the threshold voltage of charging and discharging diodes; and the definitions of other parameters are same as given above in relation to equation (1).

Similarly, as described above with reference to equation (1), the DUT capacitance, $C_{DUT}$, is determined as:

$$C_{DUT} = \frac{T(I_{AVG_{DUT}} - I_{AVG_{REF}})}{V - 2V_{th}}$$

Ideally, the resistance of the diodes is infinite when the diode is turned off with a voltage that is lower than $V_{th}$. However, this diode turn-off resistance, $R_{off}$, has finite value in a real device and it generates another factor to be considered for the calculation.

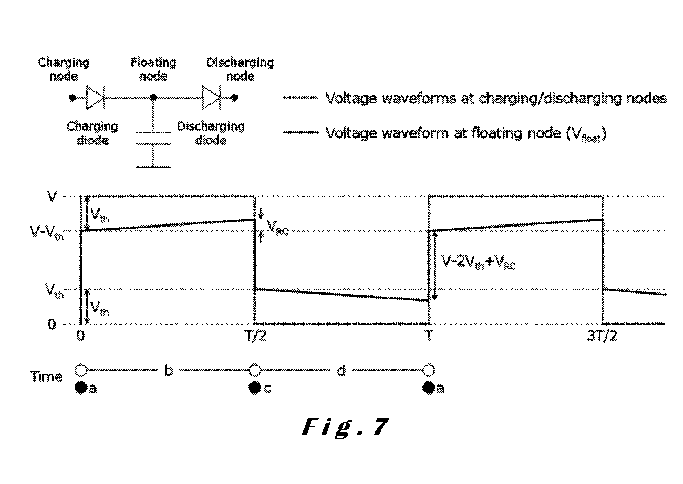

Figure 7 represents the effect of $R_{off}$. At the period 'b', $V_{float}$ increases continuously according to the elapsed time because the applied voltages at charging and discharging nodes supply charge to the DUT through the finite resistance of the turned-off diode. After the voltages at charging and discharging nodes are changed to zero at the point 'c' and the $V_{float}$ goes to $V_{th}$, $V_{float}$ cannot keep $V_{th}$ during the period 'd' and becomes lower than $V_{th}$ when both the charging and discharging nodes turned on again at the point 'a' as shown in Figure 7 for the same reason.

Therefore, this voltage difference, which is defined as $V_{RC}$ because it comes from the RC constant of diode turn-off resistance and capacitance in the structure, should be included in the calculation. The equation for capacitance calculation should be revised as:

$$C = \frac{T \times I_{AVG}}{V - 2V_{th} + V_{RC}} \qquad (3)$$

where $V_{RC}$ is the voltage difference from RC constant of diode turn-off resistance and capacitance in the structure; and the definitions of other parameters are same as given in equation (2) above.

$V_{Rc}$ is determined by the diode turn-off resistance, $R_{off}$, the capacitance in the structure, and the time period and duty cycle of clock signals at charging and discharging nodes (T/2 and T in Figure 7).

In order to use equation (3), both $V_{th}$ and $V_{Rc}$ have to be provided with accurate values for the calculation. However, $V_{th}$ and $R_{off}$ normally vary depending on process variations even though they are provided from datasheet. Moreover, the capacitance in the DUT circuit cannot be applied because it includes the capacitance value that is to be obtained from the measurement.

In one embodiment of the present invention, $V_{th}$ and $V_{RC}$ in equation (3) need to be de-embedded so that an accurate capacitance value of target structure can be extracted.

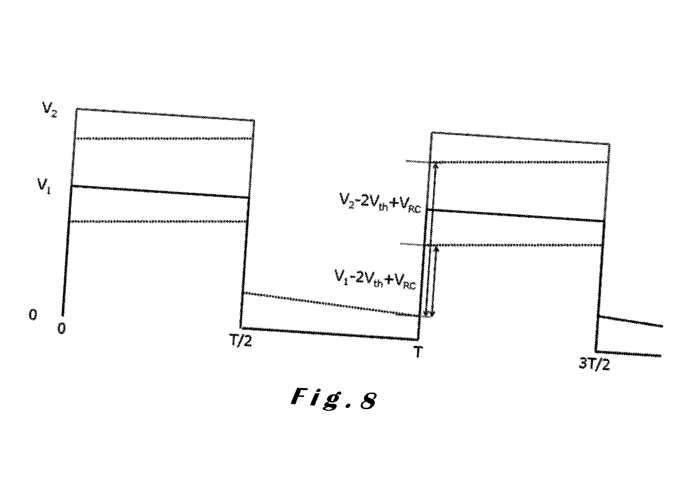

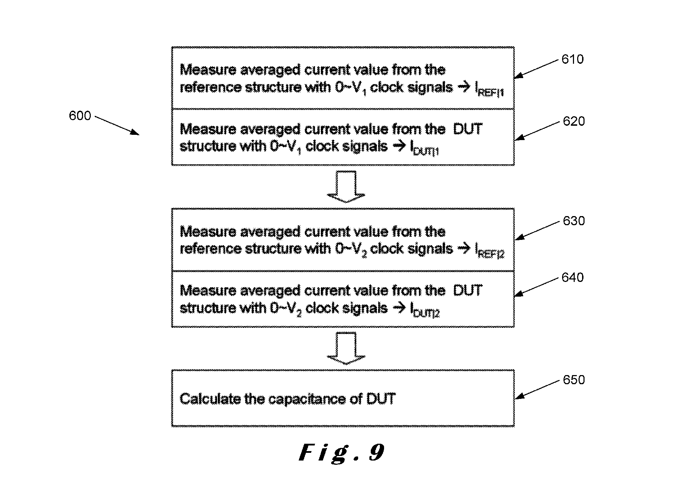

The basic principle of de-embedding in accordance with the present invention will now be described with reference to the graph shown in Figure 8 and the flow chart shown in Figure 9. First, clock signals which swing from 0 to $V_1$ with a time period, T, and an arbitrary duty cycle are applied to both the reference and DUT structures discussed above with reference to Figures 3 and 4. The voltage level of $V_1$ must be larger than $2V_{th}$ as described with reference to Figure 6. Then, the average current values from the reference structure ($I_{REF|1}$) and the DUT structure ($I_{DUT|1}$) are measured. By subtracting two equations, the capacitance of the DUT can be determined as:

$$C_{DUT} = \frac{T \times \left(I_{DUT|1} - I_{REF|1}\right)}{V_1 - 2V_{th} + V_{RC}} \tag{4}$$

Similarly, clock signals which swing from 0 to $V_2$ with the same timing configuration are applied and the two average current values ($I_{REF|2}$ and $I_{DUT|2}$) are measured again. The voltage level of $V_2$ must be larger than $2V_{th}$ as well. From these steps, the capacitance of the DUT can be determined as:

$$C_{DUT} = \frac{T \times \left(I_{DUT|2} - I_{REF|2}\right)}{V_2 - 2V_{th} + V_{RC}} \tag{5}$$

Because two measurements are using the fabricated diodes which have the same electrical properties, $V_{th}$ has an identical value for each of equations (4) and (5) above even though the process variation can slightly change the value. In addition, $V_{Rc}$ also has an identical value regardless the process variation due to uses of the same turn-off resistance, capacitance in the structure, and timing configuration of clock signal in two measurement procedures. When the equations (4) and (5) are permuted by voltages parameters as shown in equations (6) and (7) below and subtracted as shown in equation (8), the capacitance of the DUT can be calculated using equation (9) using the disclosed structure and schematic.

$$V_1 - 2V_{th} + V_{RC} = \frac{T \times \left(I_{DUT|1} - I_{REF|1}\right)}{C_{DUT}} \tag{6}$$

$$V_2 - 2V_{th} + V_{RC} = \frac{T \times \left(I_{DUT|2} - I_{REF|2}\right)}{C_{DUT}} \tag{7}$$

$$V_1 - V_2 = \frac{T \times \left[\left(I_{DUT|1} - I_{REF|1}\right) - \left(I_{DUT|2} - I_{REF|2}\right)\right]}{C_{DUT}} \tag{8}$$

$$C_{DUT} = \frac{T \times \left[\left(I_{DUT|1} - I_{REF|1}\right) - \left(I_{DUT|2} - I_{REF|2}\right)\right]}{V_1 - V_2} \tag{9}$$

where $C_{DUT}$ is the capacitance of DUT;

T is the time period of clock signal;
$I_{REF|1}$ is the average current value from the reference structure with 0-$V_1$ clock signals
$I_{DUT|1}$ is the average current value from the DUT structure with 0-$V_1$ clock signals;
$I_{REF|2}$ is the average current value from the reference structure with 0-$V_2$ clock signals; and
$I_{DUT|2}$ is the average current value from the DUT structure with 0-$V_2$ clock signals.

In the flow chart 600 shown in Figure 9, the first step, step 610, is to measure an averaged current value, $I_{REF|1}$, from the reference structure 310 (as shown in Figures 3 and 4 above) with clock signals ranging between 0 and $V_1$. At the same time, in step 620, an averaged current value, $I_{DUT|1}$, is measured from the test structure 360 (as shown in Figures 3 and 4 above) with clock signals ranging between 0 and $V_1$. The next steps correspond to steps 610 and 620 but for clock signals between 0 and $V_2$, as shown in steps 630 and 640, to provide , $I_{REF|2}$) from the reference structure 310 (as shown in Figures 3 and 4 above) and $I_{DUT|2}$, from the test structure 360. The capacitance of the DUT is then calculated using equation (9) in step 650.

The method and system of the present invention were verified by simulations where the following parameters and values were used:

| Symbol | Description | Value |
|---|---|---|
| W | Width of a diode (um) | 3.16 |
| L | Length of a diode (um) | 3.16 |
| T | Time period of clock signal (us) | 5 |
| $V_1$ | $V_1$ voltage (V) | 2.5 |
| $V_2$ | $V_2$ voltage (V) | 1.5 |
| $C_{DUT}$ | Capacitance of DUT (fF) | 100 |
| $C_{REF}$ | Capacitance of reference structure (pF) | 1 |
| $V_{th}$ | Threshold voltage of a diode (sim type) | typical |

Three specific parameter changes were made as shown below whilst keeping the other parameters at their typical values:

| | A | B | C |
|---|---|---|---|
| W&L variation ($\mu$m) | W=10 L=1 | W=3.16 L=3.16 | W=1 L=10 |
| Clock period variation ($\mu$s) | 1 | 5 | 10 |
| $V_1$ variation (V) | 2 | 2.5 | 3 |
| DUT capacitance variation (fF) | 50 | 100 | 200 |
| Reference capacitance variation (pF) | 0.5 | 1 | 2 |
| Threshold voltage variation (sim type) | slow | typical | fast |

In addition, the capacitance of DUT was calculated using the conventional method, which is described in equation (2) by applying $V_1$ to $V_2$ in order to compare the accuracy of the present invention with respect to conventional measurement techniques.

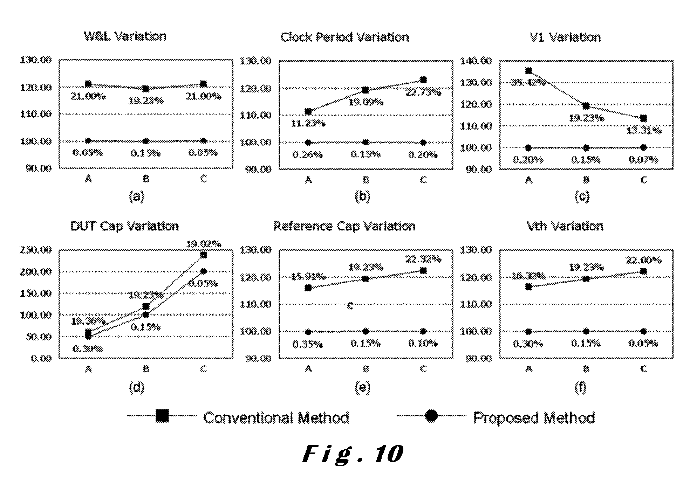

The results obtained were compared and are shown in Figure 10 where a conventional method is indicated by the square marked line, and the method of the present invention is indicated by the circle marked line. For all cases, the method of the present invention, which uses diode based structures and de-embedding method, shows less than 0.35% errors for the target values, whereas the maximum error of conventional method is up to approximately 35%.

These simulation results and comparisons show that the method and system of the present invention provide high reliability as well as high accuracy. In particular, the method of the present invention can also calculate very accurate capacitance values even though the capacitance of DUT has small values as shown in (d), the reference capacitance is varied as shown in (e) and the threshold voltage of a diode is changed as shown in (f).

The foregoing description details certain embodiments of the invention. It will be appreciated, however, that no matter how detailed the foregoing appears in text, the invention may be practised in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the invention.

**Claims**

1. A measurement system (300) for measuring the capacitance of a device-under-test (400) in an integrated circuit, the system comprising:

    a first circuit (310) forming a reference circuit; and
    a second circuit (360) forming a device-under-test circuit and into which the device-under-test is connected, the second circuit (360) being substantially identical to the first circuit;
    **characterised in that** the first and second circuits (310, 360) each comprise a first diode (320, 370) and a second diode (330, 380), the device-under-test (400) being connected between the first and second diodes (370, 380) of the second circuit (360).

2. A measurement system according to claim 1, wherein the first and second diodes (320, 330, 370, 380) each has a cathode and an anode, the cathode of the first diode (320, 370) being connected to the anode of the second diode (330, 380) in respective ones of the first and second circuits (310, 360).

3. A measurement system according to claim 1 or 2, wherein each diode (320, 330, 370, 380) is switched on and off by applying a forward and a reverse bias respectively thereto.

4. A method of measuring a capacitance value for a device-under-test (400) using the measurement system (300) according to any one of the preceding claims, the method comprising the steps of:

    a) connecting the device-under-test (400) to the second circuit (360);
    b) charging the first circuit (310) by applying a first voltage level ($V_1$) thereto;
    c) measuring a first average current value of current flowing through the first circuit (310) as it is charged;
    d) charging the second circuit (360) by applying the first voltage level ($V_1$) thereto;
    e) measuring a second average current value of current flowing through the second circuit (360) as it is charged; and
    f) determining the capacitance value for the device-under-test (400) from at least the measured first and second average current values and the first voltage level ($V_1$).

5. A method according to claim 4, wherein step c) further comprises applying a forward bias to the first diode (320) and a reverse bias to the second diode (320) so that the first circuit (310) is charged, and discharging the first circuit (310) by applying a reverse bias to the first diode (320) and a forward bias to the second diode (320).

6. A method according to claim 4 or 5, wherein step e) further comprises applying a forward bias to the first diode (370) and a reverse bias to the second diode (380) so that the second circuit (360) is charged, and discharging the second circuit (360) by applying a reverse bias to the first diode (370) and a forward bias to the second diode (380).

7. A method according to any one of claims 4 to 6, further comprising the steps of:

    g) charging the first circuit (310) by applying a second voltage level ($V_2$) thereto;
    h) measuring a third average current value of current flowing through the first circuit (310) as it is charged;
    i) charging the second circuit (360) by applying the second voltage level ($V_2$) thereto;
    e) measuring a fourth average current value of current flowing through the second circuit (360) as it is charged;

and wherein step f) comprises determining the capacitance of the device-under-test (400) from at least the measured first, second, third and average current values and the first and second voltage levels ($V_1$, $V_2$).

8. A method according to claim 7, wherein step f) further comprises adjusting the capacitance value for the device-under-test in accordance with a threshold voltage level ($V_{th}$) of the first and second diodes (320, 330, 370, 380) of the first and second circuits (310, 360).

9. A method according to claim 8, wherein step f) further comprises adjusting the capacitance value for the device-under-test in accordance with a voltage difference ($V_{RC}$) due to turn-off resistance of the first and second diodes (320, 330, 370, 380).

10. A method according to any one of claims 4 to 9, wherein step b) comprises using a clock cycle to time the charging and discharging of the first and second circuits (310, 360).

$V_{REF}$  $V_{N\text{-Well}}$  $V_{DUT}$

A  A

$C_{REF}$  $C_{REF}$  $C_{DUT}$

100
110
120
160
150
170
130
140
180
190

**Fig. 1**

Fig. 2

*Fig.3*

**Fig. 4**

*F i g . 5*

*Fig. 6*

**Fig. 7**

*Fig. 8*

600 →

Measure averaged current value from the
reference structure with 0~$V_1$ clock signals → $I_{REFI1}$ — 610

Measure averaged current value from the DUT
structure with 0~$V_1$ clock signals → $I_{DUTI1}$ — 620

⇩

Measure averaged current value from the
reference structure with 0~$V_2$ clock signals → $I_{REFI2}$ — 630

Measure averaged current value from the DUT
structure with 0~$V_2$ clock signals → $I_{DUTI2}$ — 640

⇩

Calculate the capacitance of DUT — 650

*F i g . 9*

**W&L Variation**

21.00%    19.23%    21.00%

0.05%    0.15%    0.05%

A    B    C

(a)

**Clock Period Variation**

22.73%

19.00%

11.23%

0.26%    0.15%    0.20%

A    B    C

(b)

**V1 Variation**

35.42%

19.23%

13.31%

0.20%    0.15%    0.07%

A    B    C

(c)

**DUT Cap Variation**

19.02%

19.23%    0.05%

19.36%

0.15%

0.30%

A    B    C

(d)

**Reference Cap Variation**

22.32%

19.23%

15.91%

c

0.35%    0.15%    0.10%

A    B    C

(e)

**Vth Variation**

22.00%

19.23%

16.32%

0.30%    0.15%    0.05%

A    B    C

(f)

━■━ Conventional Method    ━●━ Proposed Method

*F i g . 10*

Europäisches
Patentamt

European
Patent Office

Office européen
des brevets

**EUROPEAN SEARCH REPORT**

Application Number

EP 11 17 5637

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 838 869 B1 (ROGERS DAVID MICHAEL [US] ET AL) 4 January 2005 (2005-01-04)<br>* figures 1-3,6 *<br>* column 1, line 8 - line 12 *<br>* column 5, line 43 - column 11, line 67 *<br>----- | 1-10 | INV.<br>G01R27/26<br>G01R31/28 |
| X | US 2003/117151 A1 (KUNIKIYO TATSUYA [JP] ET AL) 26 June 2003 (2003-06-26)<br>* figures 1-9,33-35 *<br>* paragraph [0002] - paragraph [0026] *<br>* paragraph [0113] - paragraph [0150] *<br>----- | 1-10 | |
| X | US 2009/146681 A1 (JAYAPALAN JAYAKANNAN [US] ET AL) 11 June 2009 (2009-06-11)<br>* figures 3,4,6 *<br>* paragraph [0026] - paragraph [0039] *<br>----- | 1-10 | |
| X | DENNIS SYLVESTER ET AL: "Analytical Modeling and Characterization of Deep-Submicrometer Interconnect", PROCEEDINGS OF THE IEEE, IEEE. NEW YORK, US,<br>vol. 89, no. 5, 1 May 2001 (2001-05-01), XP011044509,<br>ISSN: 0018-9219<br>* the whole document *<br>----- | 1-10 | TECHNICAL FIELDS SEARCHED (IPC)<br><br>G01R |
| X | US 5 189 376 A (ROBERGE JAMES K [US] ET AL) 23 February 1993 (1993-02-23)<br>* figure 4 *<br>* column 1, line 7 - line 8 *<br>* column 1, line 59 - column 4, line 5 *<br>----- | 1-3 | |
| | -/-- | | |

The present search report has been drawn up for all claims

| Place of search | Date of completion of the search | Examiner |
|---|---|---|
| Berlin | 8 November 2011 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 11 17 5637

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2006 045737 A1 (EGO ELEKTRO GERAETEBAU GMBH [DE]) 27 March 2008 (2008-03-27) * figures 1,3 * * paragraph [0001] * * paragraph [0021] - paragraph [0033] * * paragraph [0036] * | 1-10 | |
| A | EP 1 686 383 A1 (TOKYO ELECTRON LTD [JP]) 2 August 2006 (2006-08-02) * figures 1,3-9 * * paragraph [0002] - paragraph [0019] * * paragraphs [0043], [0045] * | 1-3 | |
| A | US 5 978 197 A (CHAN VICTER [US]) 2 November 1999 (1999-11-02) * figures 1-3 * * column 3, line 20 - column 4, line 3 * | 1-3 | |
| A | US 2008/150551 A1 (KIM HAN-SU [KR]) 26 June 2008 (2008-06-26) * figures 3,6 * * paragraph [0003] * * paragraph [0110] - paragraph [0113] * | 1,4 | TECHNICAL FIELDS SEARCHED (IPC) |
| A | US 4 199 984 A (HUDDART JOHN [GB] ET AL) 29 April 1980 (1980-04-29) * figure 1 * * column 1, line 4 - line 7 * * column 9, line 55 - line 57 * | 1,4 | |

The present search report has been drawn up for all claims

| Place of search | Date of completion of the search | Examiner |
|---|---|---|
| Berlin | 8 November 2011 | Höller, Helmut |

**ANNEX TO THE EUROPEAN SEARCH REPORT
ON EUROPEAN PATENT APPLICATION NO.**

EP 11 17 5637

This annex lists the patent family members relating to the patent documents cited in the above-mentioned European search report.
The members are as contained in the European Patent Office EDP file on
The European Patent Office is in no way liable for these particulars which are merely given for the purpose of information.

08-11-2011

| Patent document cited in search report | | Publication date | Patent family member(s) | | Publication date |
|---|---|---|---|---|---|
| US 6838869 | B1 | 04-01-2005 | NONE | | |
| US 2003117151 | A1 | 26-06-2003 | CN | 1438688 A | 27-08-2003 |
| | | | JP | 2003197751 A | 11-07-2003 |
| | | | US | 2003117151 A1 | 26-06-2003 |
| US 2009146681 | A1 | 11-06-2009 | CN | 101883989 A | 10-11-2010 |
| | | | EP | 2232282 A1 | 29-09-2010 |
| | | | JP | 2011506936 A | 03-03-2011 |
| | | | KR | 20100098547 A | 07-09-2010 |
| | | | TW | 200933174 A | 01-08-2009 |
| | | | US | 2009146681 A1 | 11-06-2009 |
| | | | WO | 2009076237 A1 | 18-06-2009 |
| US 5189376 | A | 23-02-1993 | NONE | | |
| DE 102006045737 | A1 | 27-03-2008 | DE | 102006045737 A1 | 27-03-2008 |
| | | | WO | 2008034588 A1 | 27-03-2008 |
| EP 1686383 | A1 | 02-08-2006 | CN | 1826534 A | 30-08-2006 |
| | | | EP | 1686383 A1 | 02-08-2006 |
| | | | JP | 3693665 B2 | 07-09-2005 |
| | | | JP | 2005055362 A | 03-03-2005 |
| | | | KR | 20060024345 A | 16-03-2006 |
| | | | TW | I266061 B | 11-11-2006 |
| | | | US | 2008150553 A1 | 26-06-2008 |
| | | | WO | 2005015246 A1 | 17-02-2005 |
| US 5978197 | A | 02-11-1999 | NONE | | |
| US 2008150551 | A1 | 26-06-2008 | KR | 100834743 B1 | 05-06-2008 |
| | | | US | 2008150551 A1 | 26-06-2008 |
| US 4199984 | A | 29-04-1980 | GB | 1601338 A | 28-10-1981 |
| | | | US | 4199984 A | 29-04-1980 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BOTHRA, S. ; REZVANI, G.A. ; SUR, H. ; FARR, M.; ; SHENOY, J.N.** Application of charge based capacitance measurement (CBCM) technique in interconnect process development. *Interconnect Technology Conference, 1998. Proceedings of the IEEE 1998,* 1998, 181-183

- **CHEN, J.C. ; MCGAUGHY, B.W. ; SYLVESTER, D. ; CHENMING HU;.** An on-chip, attofarad interconnect charge-based capacitance measurement (CBCM) technique. *Electron Devices Meeting, 1996, IEDM '96., International, Publication Year,* 1996, 69-72